# EUROPEAN PATENT APPLICATION

(11) **EP 4 765 474 A1**
(43) Date of publication of application: **24.06.2026**
(21) Application number: 24854278.9
(22) Date of filing: 12.06.2024
(51) Int. Cl.: H01P 1/203, H01P 7/08

(54) **FILTER DEVICE**

(30) Priority: 16.08.2023 KR 20230107242
(71) Applicant: KMW Inc., Hwaseong-si, Gyeonggi-do 18462 (KR)
(72) Inventor: PARK, Nam Shin, Hwaseong-si Gyeonggi-do 18447 (KR)
(74) Representative: impuls legal PartG mbB
(86) International application number: PCT/KR2024/008034
(87) International publication number: WO 2025/037725

(57) **Abstract**

A filter device is disclosed.

According to one embodiment of the present disclosure, the provided filter device comprises: a housing; a ground member, which is disposed inside the housing and has a lower surface in contact with the housing; a wall member extending from the inner surface of the housing so as to be in contact with the ground member; a plurality of resonators disposed inside the housing, and disposed on straight lines extending in the radial direction from the ground member; an input port connected to one from among the plurality of resonators; and an output port connected to one from among the plurality of resonators, wherein the plurality of resonators are disposed to be spaced apart from each other, and one side of one or more from among the plurality of resonators is connected to the ground member.

## Description

### Technical Field

The present disclosure relates to a filter device.

### Background Art

The content described in this section is provided merely to offer background information related to the present disclosure and does not constitute prior art.

A filter is a device that blocks a signal in an undesired frequency band and allows only a signal in a desired band to pass there through by using frequency response. Filters include a high-pass filter (HPF), a band-pass filter (BPF), and a low-pass filter (LPF).

A high-pass filter (HPF) is a filter that allows a high-frequency signal to pass there through and blocks a low-frequency signal. A band-pass filter (BPF) is a filter that allows a signal within a predetermined specific frequency bandwidth to pass there through and blocks a signal outside the bandwidth. A low-pass filter (LPF) is a filter that allows a low-frequency signal to pass there through and blocks a high-frequency signal.

Depending on frequency signals that a filter allows to pass and frequency signals that the filter blocks, a frequency response graph has a varying waveform. A passband refers to a range of frequencies that the filter allows to pass there through. A stopband refers to a range of frequencies that the filter blocks. Frequency responses are important factors that determine responses of the filter.

It is not easy to obtain desired frequency responses. In order to obtain desired frequency responses, a device of the filter may become complicated and manufacturing processes may increase, thereby increasing manufacturing cost. For example, a notch may be generated to obtain desired frequency responses. The notch refers to a section in which an amplitude of the frequency response graph is sharply reduced. When the notch is formed, attenuation performance is improved; however, in order to form the notch, installation of an additional device may be required.

### Detailed Description of the Invention

### Technical Problem

Accordingly, the present disclosure has been made to solve the above-described problems, and a primary object thereof is to provide a filter device capable of generating a notch on a frequency response graph without installing an additional structure.

In addition, a primary object of the present disclosure is to provide a filter device in which cross-coupling occurs between non-adjacent resonators.

In addition, a primary object of the present disclosure is to provide a filter device in which resonators are arranged in an interdigital form so as to easily form a notch at a desired frequency.

### Technical Solution

According to an embodiment of the present disclosure for achieving the above-described objects, a filter device is provided, the filter device comprising: a housing; a ground member disposed inside the housing and having one side in contact with the housing; a wall member in contact with an inner surface of the housing; a first ring member having an inner circumferential surface in contact with the ground member; a second ring member having an outer circumferential surface in contact with the housing; a plurality of resonators disposed between the first ring member and the second ring member and disposed on straight lines extending in a radial direction from a center of the housing; an input port connected to one of the plurality of resonators; and an output port connected to another one of the plurality of resonators, wherein the plurality of resonators are disposed to be spaced apart from each other, and at least one of the plurality of resonators has one side in contact with the first ring member.

### Effects of the Invention

As described above, according to the present embodiment, the filter device has an effect of generating a notch on a frequency response graph without installing an additional structure.

In addition, the present disclosure has an effect in which cross-coupling may occur between non-adjacent resonators.

In addition, the present disclosure has an effect of easily forming a notch at a desired frequency by arranging the resonators in an interdigital form.

### Brief Description of the Drawings

FIG. 1 is an exploded perspective view of a filter device according to a first embodiment of the present disclosure.
FIG. 2 is a plan view of the filter device according to the first embodiment of the present disclosure.
FIG. 3 is a cross-sectional view of the filter device according to the first embodiment of the present disclosure.
FIG. 4 is a frequency response graph according to the first embodiment of the present disclosure.
FIG. 5 is an exploded perspective view of a filter device according to a second embodiment of the present disclosure.
FIG. 6 is a plan view of the filter device according to the second embodiment of the present disclosure.
FIG. 7 is a frequency response graph according to the second embodiment of the present disclosure.
FIG. 8 is an exploded perspective view of a filter device according to a third embodiment of the present disclosure.
FIG. 9 is a plan view of the filter device according to the third embodiment of the present disclosure.
FIG. 10 is a frequency response graph according to the third embodiment of the present disclosure.
FIG. 11 is an exploded perspective view of a filter device according to a fourth embodiment of the present disclosure.
FIG. 12 is a plan view of the filter device according to the fourth embodiment of the present disclosure.
FIG. 13 is a frequency response graph according to the fourth embodiment of the present disclosure.
FIG. 14 is an exploded perspective view of a filter device according to a fifth embodiment of the present disclosure.
FIG. 15 is a plan view of the filter device according to the fifth embodiment of the present disclosure.
FIG. 16 is a frequency response graph according to the fifth embodiment of the present disclosure.

### Detailed Description of the Invention

Hereinafter, some embodiments of the present disclosure will be described in detail with reference to the accompanying exemplary drawings. In adding reference numerals to elements of the drawings, the same reference numerals are used to denote the same elements even though they are illustrated in different drawings, as much as possible. In addition, in describing the present disclosure, detailed descriptions of related known configurations or functions will be omitted when it is determined that such descriptions may obscure the gist of the present disclosure.

In describing elements of the present disclosure, terms such as first, second, A, B, (a), and (b) may be used. Such terms are used only to distinguish one element from another, and do not limit the nature, order, or sequence of the corresponding elements.

When it is described that one element is "connected," "coupled," or "joined" to another element, it should be understood that the one element may be directly coupled or joined to the other element, but another element may also be "connected," "coupled," or "joined" between the respective components.

Throughout the specification, when a part is described as "comprising" or "including" an element, this does not exclude other elements unless explicitly stated otherwise, and means that other elements may be further included.

In the specification, terms such as "unit" and "module" refer to a unit that processes at least one function or operation, and may be implemented as hardware, software, or a combination of hardware and software.

Unless stated otherwise, the description of an embodiment may be applied to other embodiments.

The description of the present disclosure disclosed below with reference to the accompanying drawings is intended to describe exemplary embodiments of the present disclosure, and is not intended to represent the only embodiments in which the present disclosure may be practiced.

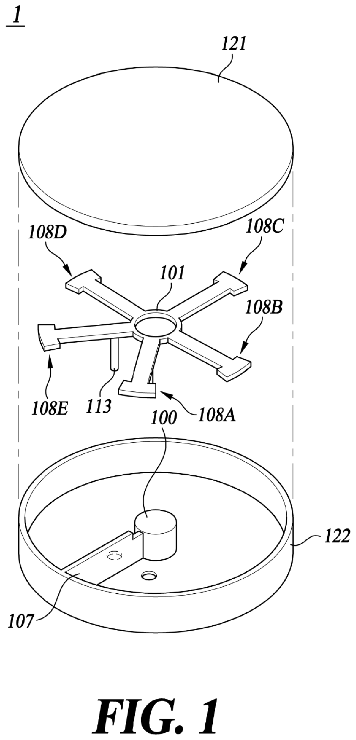

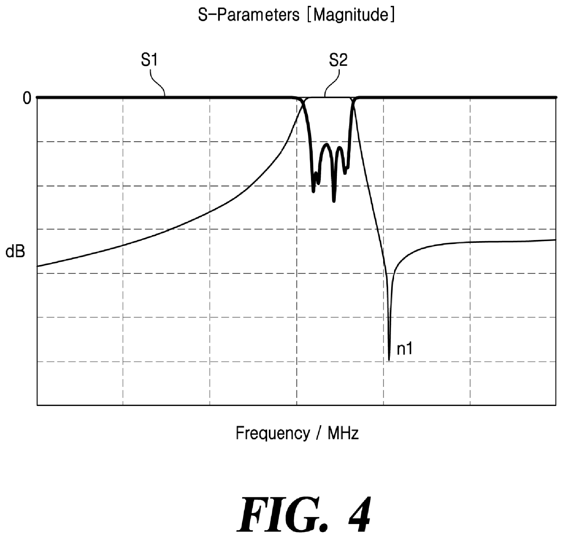

FIGS. 1 to 4 are each view showing a filter device and a frequency response graph according to a first embodiment of the present disclosure.

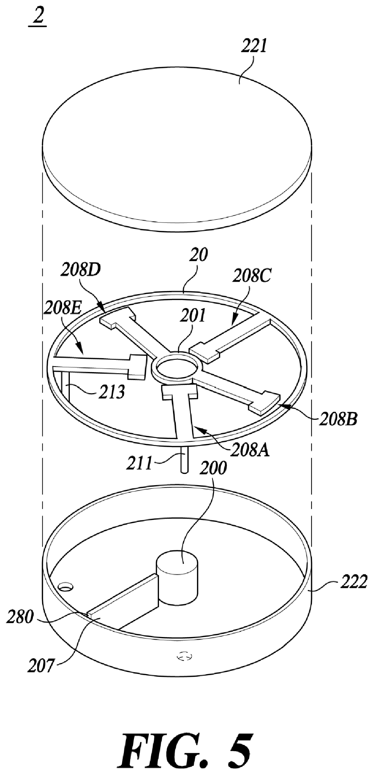

FIGS. 5 to 7 are each view showing a filter device and a frequency response graph according to a second embodiment of the present disclosure.

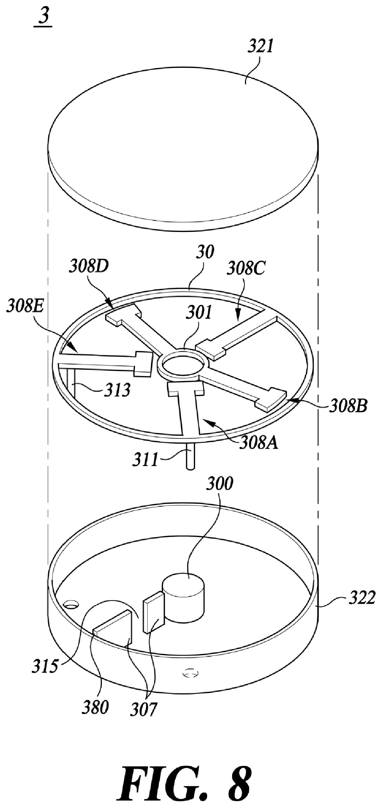

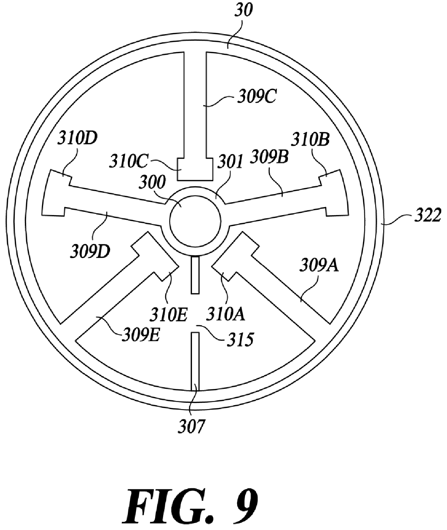

FIGS. 8 to 10 are each view showing a filter device and a frequency response graph according to a third embodiment of the present disclosure.

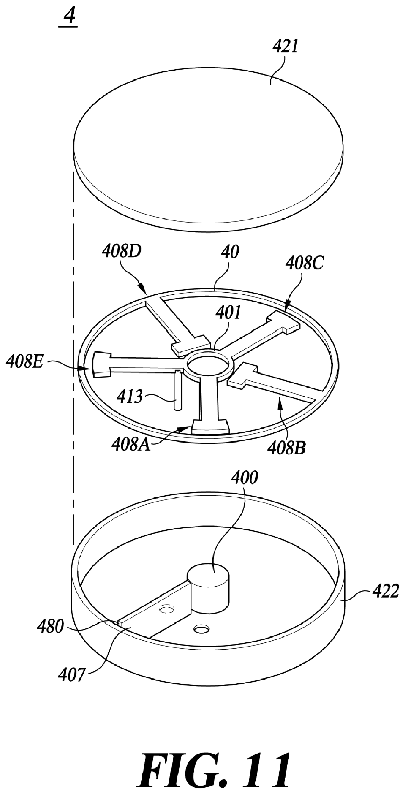

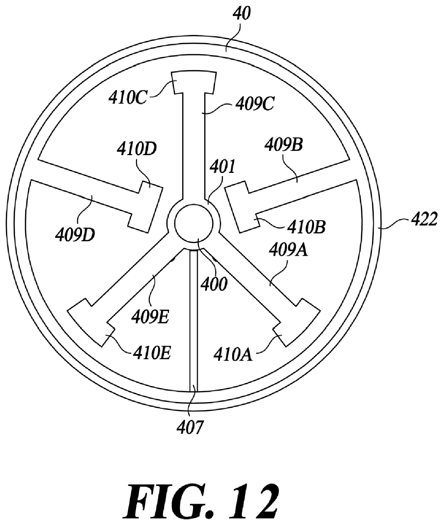

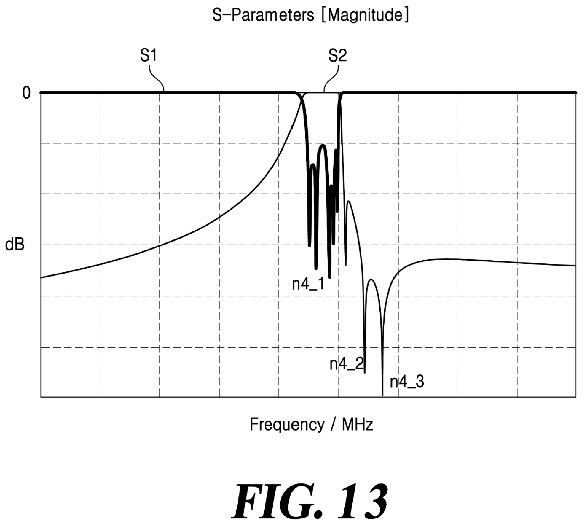

FIGS. 11 to 13 are each view showing a filter device and a frequency response graph according to a fourth embodiment of the present disclosure.

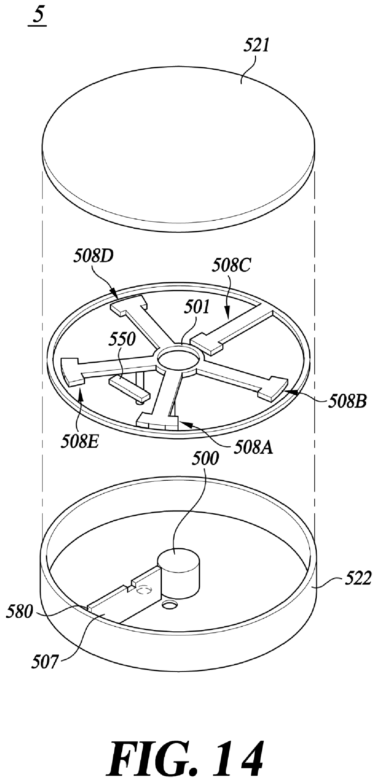

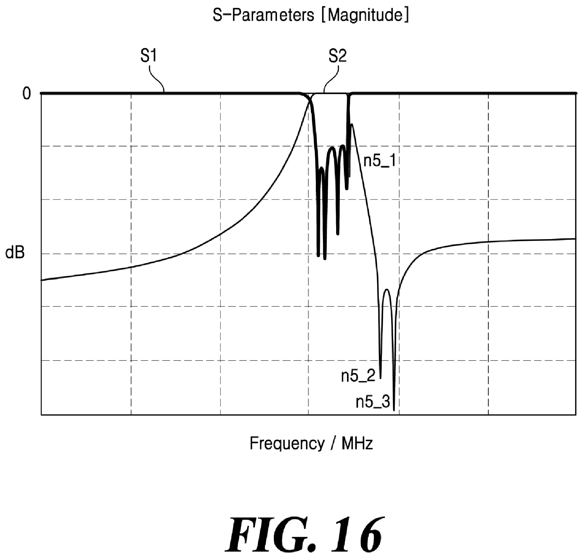

FIGS. 14 to 16 are each view showing a filter device and a frequency response graph according to a fifth embodiment of the present disclosure.

Hereinafter, features of the filter device (1 to 5) according to the present disclosure will be described with reference to the first embodiment (FIGS. 1 to 4) and/or the second embodiment (FIGS. 5 to 7). For portions without contradiction, descriptions will be made with reference to the reference numerals of the drawings of the first embodiment and/or the second embodiment. For example, with respect to a plurality of resonators (108, 208, 308, 408, 508) according to various embodiments, for the sake of brevity of the specification, the resonators will be briefly described using reference numeral 108 of the drawings of the first embodiment and/or reference numeral 208 of the drawings of the second embodiment. With respect to features not included in the first embodiment and/or the second embodiment, descriptions will be made with reference to the third to fifth embodiments or will be described later.

Referring to FIGS. 1 to 16, the filter device (1 to 5) according to the present disclosure includes all or some of a housing (120), a ground member (100), a wall member (107), a plurality of resonators (108, 208), an input port (111), an output port (113), first ring member (101), second ring member (20) and a penetration member (550).

The housing (120) accommodates components therein. The housing (120) may include an upper case (121) and a lower case (122). The size and shape of the housing (120) are not limited by the disclosure of the drawings. An upper surface of the upper case (121) of the housing (120) may have a circular shape. A lower surface of the lower case (122) of the housing (120) may have a circular shape. A longitudinal cross section of the housing (120) may have a circular shape. The longitudinal cross section of the housing (120) may have a polygonal shape. Frequency responses of the filter device (1 to 5) may vary depending on the shape of the housing (120) and a size of an accommodating space inside the housing (120). The size and shape of the housing (120) may be adjusted to meet required specifications.

The first ring member (101) may be in contact with the ground member (100). A shape of the first ring member (101) may be a circular ring. The shape of the first ring member (101) may be a polygonal ring, such as a square ring or a pentagonal ring.

The first ring member (101) may be fitted onto the ground member (100). In this case, an inner surface of the first ring member (101) may be in contact with an outer surface of the ground member (100).

The first ring member (101) may be in contact with the resonator (108). The resonator (108) may be formed to extend from the first ring member (101). The resonator (108) that is in contact with the first ring member (101) is not in contact with the second ring member (20).

The second ring member (20) may be in contact with the housing (120). A shape of the second ring member (20) may be a circular ring. The shape of the second ring member (20) may be a polygonal ring, such as a square ring or a pentagonal ring.

The second ring member (20) may be fitted into the housing (120). In this case, an outer surface of the second ring member (20) may be in contact with an inner surface of the housing (120).

The second ring member (20) may be in contact with the resonator (208). The resonator (208) may be formed to extend from the second ring member (20). The resonator (208) that is in contact with the second ring member (20) is not in contact with the first ring member (201).

The first ring member (101, 201) and/or the second ring member (20) may be formed integrally with one or more among the plurality of resonators (108, 208).

The second ring member (20) may be in contact with an inner surface of the housing (120). A cross section of the inner surface of the housing (120) that is perpendicular to a longitudinal direction of the inner surface may have a polygonal shape. The inner surface of the housing (120) that is in contact with the second ring member (20) is not a flat surface having a curvature of zero. When the resonator (208) is formed to extend from the second ring member (20), cross coupling to be described later may occur. Since arrangement directions of the plurality of resonators (108, 208) formed to extend from the second ring member (20) are not parallel to each other, cross coupling may occur. That is, the filter device (1 to 5) according to the present disclosure does not need to install additional structures on the plurality of resonators (108, 208) in order to generate cross coupling.

The ground member (100) is disposed inside the housing (120). The ground member (100) may be disposed at a center of the housing (120). The ground member (100) and the housing (120) may be formed integrally with each other.

A shape of a cross section of the ground member (100) in a longitudinal direction may be a circular shape. The shape of the cross section of the ground member (100) in the longitudinal direction may be a polygonal shape. A size and a shape of the ground member (100) are not limited by the disclosure of the drawings. The first ring member (101) may be in contact with the plurality of resonators (108, 208). An outer surface of the ground member (100) is not a flat surface having a curvature of zero. When the resonator (108) is formed to extend from the first ring member (101), cross coupling to be described later may occur. Since arrangement directions of the plurality of resonators (108, 208) formed to extend from the first ring member (101) are not parallel to each other, cross coupling may occur. That is, additional structures do not need to be installed on the plurality of resonators (108, 208) in order to generate cross coupling.

The ground member (100) may be in contact with the wall member (107). A portion of the wall member (107) may be inserted into the ground member (100).

According to an embodiment, the ground member (100) may be in contact with one side of the housing (120). Another side of the ground member (100) may not be in contact with the housing (120). Specifically, a lower surface (103) of the ground member (100) may be in contact with a lower case (122) of the housing (120), and an upper surface of the ground member (100) may not be in contact with the housing (120). In this case, an empty space may be formed between the housing (120) and the upper surface of the ground member (100), such that cross coupling may occur. The cross coupling refers to a phenomenon in which an electrical connection occurs between non-adjacent resonators (108). For example, the cross coupling may occur when a first resonator (108A) and a third resonator (108C), which are not adjacent to each other, are electrically connected to each other. Due to the cross coupling, notches (n) of various shapes may be generated. Shapes of the notches (n) that may be generated due to the cross coupling are not limited by shapes disclosed in the drawings. The notch (n) refers to a portion in which a waveform of a frequency response graph rapidly changes and decreases. The notch (n) may be utilized to obtain desired frequency responses, such as improvement of attenuation performance. For example, the notch (n) may be generated on a left side and/or a right side with respect to a passband illustrated in the frequency response graph.

In order to obtain frequency responses satisfying desired conditions, shapes, sizes, positions, numbers, and the like of the ground member (100), the housing (120), the plurality of resonators (108, 208), the wall member (107), the passage (315), the penetration member (550), the first ring member (101), and the second ring member (20) may be adjusted, and a notch may be generated.

The wall member (107) may be in contact with an inner surface of the housing (120). The wall member (107) may be in contact with an upper surface and a lower surface of the housing (120). The wall member (107) may be formed to extend from the inner surface of the housing (120). The wall member (107) may be formed integrally with the housing (120). The wall member (107) may be in contact with the ground member (100). The wall member (107) may be in contact with the first ring member (101). The wall member (107) may be in contact with the second ring member (20). The wall member (107) may be disposed between a resonator connected to the input port (111) and a resonator connected to the output port (113). For example, the wall member (107) may be disposed between the first resonator (108A) and the fifth resonator (108E). The wall member (107) may be disposed to be in contact with an upper case (121). The wall member (107) may be disposed to be in contact with a lower surface of the housing (120). For example, the wall member (107) may be disposed to be in contact with a lower case (122).

The wall member (107) may block an electrical connection between the plurality of resonators (108, 208). For example, an electrical connection may be prevented from occurring by using a path (P1) penetrating the wall member (107). For example, an electrical connection between a first resonator (108A) and a fifth resonator (108E), which are disposed adjacent to each other, may be blocked.

By adjusting shapes, sizes, positions, and numbers of the wall member (107), frequency responses of the filter device (1 to 5), a number of notches (n), and positions of the notches (n) may be adjusted. The shapes, sizes, positions, and numbers of the wall member (107) are not limited by the disclosure of the drawings.

The wall member (107) may comprise a passage (315) for generating an electrical connection between the plurality of resonators (108, 208). Although the wall member (107) functions to block an electrical connection, when the wall member comprises the passage (315), an electrical connection may occur between the plurality of resonators (108, 208). By adjusting a shape, a size, a position, and a number of the passage (315), frequency responses of the filter device (1 to 5), a position of a notch (n), and a number of notches (n) may be adjusted. The shape, size, position, and number of the passage (315) are not limited by the disclosure of the drawings. For example, the passage (315) may be formed to be smaller than a shape illustrated in the drawings. For example, unlike the drawings, the passage (315) may have a circular shape, a polygonal shape, or the like.

The wall member (107) may comprise a groove (280) for seating the second ring member (20). A size, a shape, and a position of the groove (280) are not limited by the drawings.

The wall member (107) may be in contact with the ground member (100), as shown in FIG. 1. The wall member (107) may not be in contact with the ground member (200), as shown in FIG. 5.

The plurality of resonators (108, 208) are disposed inside the housing (120). In order to obtain a desired notch and/or desired frequency responses, a shape, a size, a position, a number, and the like of the resonators (108) may be adjusted. The plurality of resonators (108, 208) may be disposed to be spaced apart from each other. The plurality of resonators (108, 208) may be disposed between the first ring member (101) and the second ring member (20). The plurality of resonators (108, 208) may be disposed on straight lines extending in a radial direction from a center of the housing (120) so as to be disposed between the first ring member (101) and the second ring member (20).

The plurality of resonators (108, 208) may be disposed so as not to be parallel to each other. A shape of an outer surface of the first ring member (101) may be formed such that the plurality of resonators (108, 208) are disposed to be not parallel to each other. A shape of an inner surface of the second ring member (20) may be formed such that the plurality of resonators (108, 208) are disposed to be not parallel to each other. When the plurality of resonators (108, 208) are disposed so as not to be parallel to each other, cross coupling, which is a phenomenon in which an electrical connection occurs between non-adjacent resonators, may occur. Desired frequency responses may be obtained by controlling the cross coupling.

According to an embodiment, at least one of the plurality of resonators (108, 208) may be in contact with the first ring member (101). The resonator (108) that is in contact with the first ring member (101) may not be in contact with the second ring member (20).

According to an embodiment, one or more of the plurality of resonators (108, 208) may not be in contact with the first ring member (101). The resonator (108) that is not in contact with the first ring member (101) may be in contact with the second ring member (20).

One or more of the plurality of resonators (108, 208) may comprise a head portion (110). The head portion (110) may be formed on a body (109) of the resonator (108). By adjusting a shape, a size, a position, a number, and the like of the head portion (110), a frequency response graph of the filter device (1 to 5), a position of a notch (n), and a number of notches (n) may be varied.

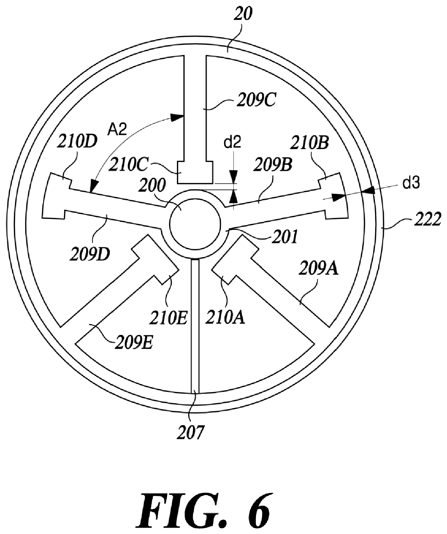

According to an embodiment, a resonator (108) among the plurality of resonators (108, 208) that is in contact with the first ring member (101) may comprise the head portion (110) at an end adjacent to the second ring member (20). According to an embodiment, a resonator among the plurality of resonators (108, 208) that is in contact with the second ring member (20) may comprise the head portion (110) at an end adjacent to the first ring member (101). For example, among the resonators (208) of the second embodiment (FIGS. 5 and 6), a second resonator (208B) and a fourth resonator (208D), which are connected to the first ring member (201), may comprise head portions (210B, 210D) at ends adjacent to the second ring member (20). For example, a first resonator (208A), a third resonator (208C), and a fifth resonator (208E), which are not connected to the first ring member (201), may comprise head portions (210A, 210C, 210E) at ends adjacent to the first ring member (201).

Shapes, sizes, positions, and numbers of the plurality of resonators (108, 208) are not limited by the disclosure of the drawings. A size and/or a shape of each of the plurality of resonators (108, 208) may be independently formed.

Unlike conventional resonators that are disposed perpendicular to a flat surface having a curvature of zero, the plurality of resonators (108, 208) according to the present disclosure are disposed to be in contact with the first ring member (101) or are disposed to be in contact with the second ring member (20). That is, the plurality of resonators (108, 208) according to the present disclosure are disposed so as not to be parallel to each other. Since the plurality of resonators are not parallel to each other, cross coupling may occur. While conventional resonators require installation of additional structures in order to generate cross coupling, the plurality of resonators (108, 208) according to the present disclosure may generate cross coupling without additional structures. That is, an effect of reducing manufacturing cost may be achieved.

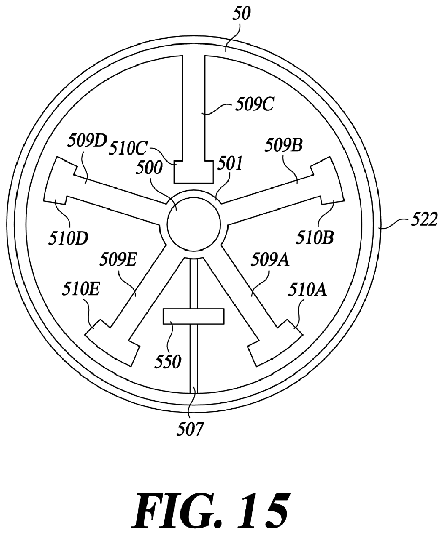

All or some of the plurality of resonators (108, 208) may be arranged in an interdigital form. The interdigital form refers to a form in which resonators (108, 208) connected to the first ring member (101, 201) and resonators (208) connected to the second ring member (20) are alternately arranged. For example, in the second embodiment (FIGS. 5 and 6), a first resonator (208A) connected to the second ring member (20), a second resonator (208B) connected to the first ring member (101), a third resonator (208C) connected to the second ring member (20), a fourth resonator (208D) connected to the first ring member (101), and a fifth resonator (208E) connected to the second ring member (20) are alternately arranged. As illustrated in the fifth embodiment (FIGS. 14 and 15), it is also possible that only some of the plurality of resonators (508) are arranged in the interdigital form. For example, a second resonator (508B), a third resonator (508C), and a fourth resonator (508D) of the fifth embodiment are arranged in the interdigital form. When arranged in the interdigital form, a plurality of notches (n) may be easily formed. Desired frequency responses may be obtained by using the interdigital arrangement.

The input port (111) may be connected to one of the plurality of resonators (108, 208). The output port (113) may be connected to one of the plurality of resonators (108, 208).

According to an embodiment, the resonator (108) connected to the input port (111) and the resonator (108) connected to the output port (113) may be disposed adjacent to each other. According to an embodiment, the wall member (107) may be disposed between the resonator (108) connected to the input port (111) and the resonator (108) connected to the output port (113).

The penetration member (550) may penetrate the wall member (107, 507). The penetration member (550) may be fixed by the wall member (107, 507). One or more penetration members (550) penetrating the wall member (107, 507) may be provided. Although the wall member (107, 507) performs a function of blocking an electrical connection, an electrical connection may occur between the plurality of resonators (508) by the penetration member (550).

A shape, a size, a position, a number, and the like of the penetration member (550) are not limited by the disclosure of the drawings. The penetration member (550) disclosed in FIG. 14 is disposed closer to an upper surface of the housing (120) than to a lower surface of the housing (120); however, the present disclosure is not limited thereto. The penetration member (550) may be disposed closer to the lower surface of the housing (120). The penetration member (550) may be disposed on the same plane as the plurality of resonators (108, 208). By adjusting the shape, the size, the position, the number, and the like of the penetration member (550), frequency responses, a position of a notch (n), and a number of notches (n) may be adjusted.

A first embodiment will be described below. Descriptions will focus on matters not previously described. Descriptions overlapping with those described above will be omitted or briefly described.

Referring to FIGS. 1 to 4, according to a first embodiment of the present disclosure, all of the plurality of resonators (108) may be connected to the first ring member (101). The filter device (1) according to the first embodiment may comprise a first resonator (108A) to a fifth resonator (108E). The first resonator (108A) is connected to the input port (111), and the fifth resonator (108E) may be connected to the output port (113).

In the filter device (1) according to the first embodiment, cross coupling may occur. For example, the first resonator (108A) may be electrically connected to non-adjacent resonators, such as the third resonator (108C), the fourth resonator (108D), and the fifth resonator (108E). A notch (n1) may be generated by the cross coupling. The notch (n1) may be generated on a right side with respect to a passband of a frequency response graph.

The first resonator (108A) to the fifth resonator (108E) are disposed so as not to be parallel to each other. This is because a shape of an outer surface of the first ring member (101) is not a planar surface having zero curvature. Head portions (110) of the first resonator (108A) to the fifth resonator (108E) are disposed to face different directions from each other. Since the first resonator (108A) to the fifth resonator (108E) are not parallel to each other, cross coupling may occur.

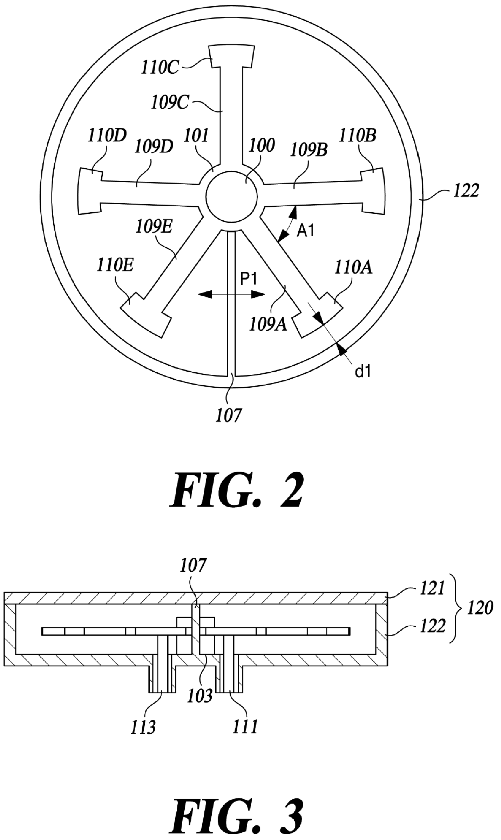

An upper surface of the ground member (100) and an upper surface of the housing (120) are not in contact with each other (FIG. 3). That is, an empty space is formed between the upper surface of the ground member (100) and the upper surface of the housing (120). Due to the empty space, cross coupling may occur between the plurality of resonators (108).

Frequency responses may vary depending on an angle between adjacent resonators (108). For example, when an angle (A1, FIG. 2) between a first resonator (108A) and a second resonator (108B), which are adjacent to each other, is varied, a waveform of a frequency response graph, a position of a notch (n1), a number of notches (n1), and a magnitude of amplitude reduction may be varied. Angles between the plurality of resonators (108) may be independently formed. For example, the angle (A1) between the first resonator (108A) and the second resonator (108B) and an angle between the second resonator (108B) and a third resonator (108C) may be the same as or different from each other.

Frequency responses may vary depending on a distance between a head portion (110) and an inner surface of the housing (120). For example, when a distance (d1) between a first head portion (110A) and the inner surface of the housing (120) in FIG. 2 is varied, a waveform of a frequency response graph, a position of a notch (n1), a number of notches (n1), and a magnitude of amplitude reduction may be varied. Distances between the head portion (110) and the inner surface of the housing (120) may be independently formed. For example, the distance (d1) between the first head portion (110A) and the inner surface of the housing (120) and a distance between a second head portion (110B) and the inner surface of the housing (120) may be the same as or different from each other.

A second embodiment will be described below. Descriptions will focus on matters not previously described. Descriptions overlapping with those described above will be omitted or briefly described.

Referring to FIGS. 5 to 7, a filter device (2) according to a second embodiment of the present disclosure may comprise a first resonator (208A) to a fifth resonator (208E). The first resonator (208A) to the fifth resonator (208E) may be sequentially arranged along a counterclockwise direction about the first ring member (201) and/or the ground member (200). The first resonator (208A) is connected to the input port (211), and the fifth resonator (208E) may be connected to the output port (213).

According to the second embodiment of the present disclosure, the first resonator (208A), the third resonator (208C), and the fifth resonator (208E) may be joined to the second ring member (20), and the second resonator (208B) and the fourth resonator (208D) may be joined to the first ring member (201). According to the second embodiment, a notch (n2) may be generated on a right side with respect to a passband illustrated in a frequency response graph.

According to the second embodiment, an arrangement of the plurality of resonators (208) may be in an interdigital form. Specifically, a first resonator (208A) joined to the second ring member (20), a second resonator (208B) joined to the first ring member (201), a third resonator (208C) joined to the second ring member (20), a fourth resonator (208D) joined to the first ring member (201), and a fifth resonator (208E) joined to the second ring member (20) may be sequentially arranged. When the plurality of resonators is arranged in the interdigital form, a plurality of notches (n) may be easily formed. Desired frequency responses may be obtained by using the interdigital arrangement.

Frequency responses may vary depending on an angle between adjacent resonators (208) and a distance between the head portion (210) and the second ring member (20). For example, when an angle (A2) of the second embodiment (FIG. 6) is changed, the frequency responses may vary. For example, when a distance (d3) between a second head portion (210B) and the second ring member (20) in FIG. 6 is changed, a waveform of a frequency response graph, a position of a notch (n1), a number of notches (n1), and a magnitude of amplitude reduction may be changed. Distances between the head portion (210) and the second ring member (20) may be formed independently of each other. For example, the distance (d3) between the second head portion (210B) and the second ring member (20) and a distance between a fourth head portion (210D) and the second ring member (20) may be the same as or different from each other.

Frequency responses may vary depending on a distance between the first ring member (201) and the head portion (210). For example, when a distance (d2) between a third head portion (210C) and the first ring member (201) in FIG. 6 is varied, a waveform of a frequency response graph, a position of a notch (n2), a number of notches (n2), and a magnitude of amplitude reduction may be varied.

Frequency responses may vary depending on a size of the head portion (210) and a shape of the head portion (210). Referring to FIG. 6, the third head portion (210C) has a smaller size than other head portions (210). The third head portion (210C) has a different shape compared to other head portions (210). For example, the third head portion (210C) has a shape different from that of an adjacent fourth head portion (210D). As in the third embodiment, desired frequency responses may be obtained by adjusting sizes and shapes of the head portions (210).

Each of the plurality of resonators (208) may be formed integrally with the first ring member (201) or may be formed integrally with the second ring member (20). For example, in FIG. 5, the first resonator (208A) may be formed integrally with the second ring member (20). For example, in FIG. 5, the second resonator (208B) may be formed integrally with the first ring member (201).

A third embodiment will be described below. Descriptions will focus on matters not previously described. Descriptions overlapping with those described above will be omitted or briefly described.

Referring to FIGS. 8 to 10, a filter device (3) according to a third embodiment of the present disclosure may comprise a first resonator (308A) to a fifth resonator (308E). The first resonator (308A) to the fifth resonator (308E) may be sequentially arranged along a counterclockwise direction about the first ring member (301) and/or the ground member (300). The first resonator (308A) may be connected to the input port (311), and the fifth resonator (308E) may be connected to the output port (313).

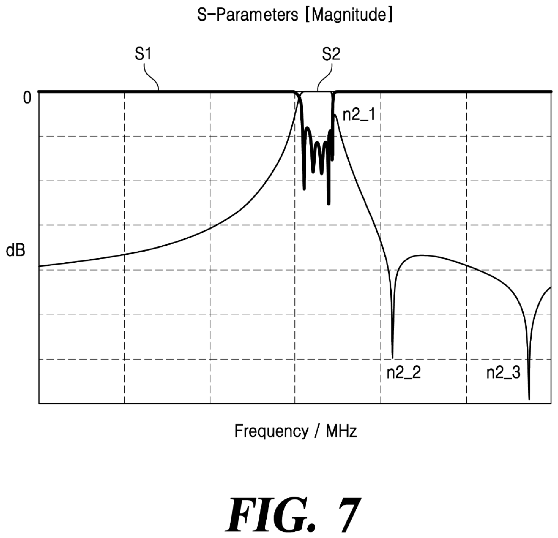

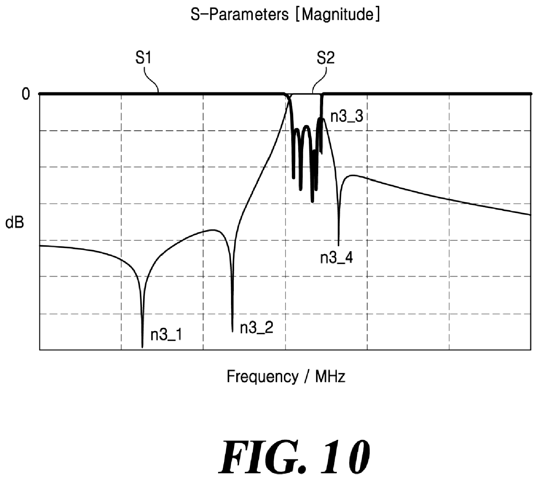

According to the third embodiment, the filter device (3) may comprise a passage (315). The passage (315) enables an electrical connection between the plurality of resonators (308). Depending on the passage (315), a waveform of a frequency response graph, a position of a notch (n3), a number of notches (n3), and a magnitude of amplitude reduction may be varied. A greatest difference between the third embodiment (FIGS. 8 to 10) and the second embodiment (FIGS. 5 to 7) is whether the passage (315) is included. Due to presence or absence of the passage (315), the third embodiment and the second embodiment have different frequency responses (FIGS. 7 and 10). Specifically, in the third embodiment, notches (n3) are generated on left and right sides with respect to a passband, whereas in the second embodiment, a notch (n2) is generated on a right side with respect to the passband.

A fourth embodiment will be described below. Descriptions will focus on matters not previously described. Descriptions overlapping with those described above will be omitted or briefly described.

Referring to FIGS. 11 to 13, a filter device (4) according to a fourth embodiment of the present disclosure may comprise a first resonator (408A) to a fifth resonator (408E). The first resonator (408A) to the fifth resonator (408E) may be sequentially arranged along a counterclockwise direction about the first ring member (401) and/or the ground member (400). The first resonator (408A) is connected to the input port (411), and the fifth resonator (408E) may be connected to the output port (413). According to the fourth embodiment, the first resonator (408A), the third resonator (408C), and the fifth resonator (408E) may be connected to the first ring member (401), and the second resonator (408B) and the fourth resonator (408D) may be connected to the second ring member (40). According to the fourth embodiment, a notch (n4) may be generated on a right side with respect to a passband illustrated in a frequency response graph.

According to the fourth embodiment, an arrangement of the plurality of resonators (408) may be in an interdigital form. Specifically, a first resonator (408A) connected to the first ring member (401), a second resonator (408B) connected to the second ring member (40), a third resonator (408C) connected to the first ring member (401), a fourth resonator (408D) connected to the second ring member (40), and a fifth resonator (408E) connected to the first ring member (401) may be sequentially arranged. When the plurality of resonators is arranged in the interdigital form, a plurality of notches (n4) may be easily formed. Desired frequency responses may be obtained by using the interdigital arrangement.

A fifth embodiment will be described below. Descriptions will focus on matters not previously described. Descriptions overlapping with those described above will be omitted or briefly described.

Referring to FIGS. 14 to 16, a filter device (5) according to a fifth embodiment of the present disclosure may comprise a first resonator (508A) to a fifth resonator (508E). The first resonator (508A) to the fifth resonator (508E) may be sequentially arranged along a counterclockwise direction about the first ring member (501) and/or the ground member (500). The first resonator (508A) is connected to the input port (511), and the fifth resonator (508E) may be connected to the output port (513).

According to the fifth embodiment, the first resonator (508A), the second resonator (508B), the fourth resonator (508D), and the fifth resonator (508E) may be connected to the first ring member (501). The third resonator (508C) may be connected to the second ring member (50). The wall member (507) may be disposed between the first resonator (508A) and the fifth resonator (508E).

According to the fifth embodiment, the filter device (5) may further comprise the penetration member (550) penetrating the wall member (507). A shape of the penetration member (550) is not limited by the disclosure of the drawings. For example, the penetration member (550) may have a cylindrical shape. The penetration member (550) may have a spherical shape.

Although the wall member (507) blocks an electrical connection, when the wall member (507) comprises the penetration member (550), an electrical connection may occur. For example, the first resonator (508A) and the fifth resonator (508E) may be electrically connected by the penetration member (550).

According to the fifth embodiment, a notch (n5) may be generated on a right side with respect to a passband illustrated in a frequency response graph.

According to the fifth embodiment, only a portion of the plurality of resonators (508) may be arranged in an interdigital form. For example, in the fifth embodiment, a second resonator (508B), a third resonator (508C), and a fourth resonator (508D) are arranged in the interdigital form.

According to another embodiment, the filter device (1 to 5) according to the present disclosure may not include the first ring member (101) and/or the second ring member (20). For example, when the first ring member (101) is not included, all of the plurality of resonators (108, 208) may be connected to the second ring member (20).

Another embodiment of the present disclosure will be described. The filter devices (1 to 5) of the present disclosure may be configured to be implemented in a microstrip line form or a strip line form by using a dielectric substrate. Here, the dielectric substrate may be a printed circuit board (PCB) substrate. In this case, the plurality of resonators (108, 208) may be configured to be disposed between dielectric substrates formed in multiple layers. As such, configurations and/or shapes of the filter devices (1 to 5) of the present disclosure are not limited by the disclosure of the drawings. The plurality of resonators (108, 208) may be disposed between various components, and even in this case, since the plurality of resonators may have an arrangement device in which the plurality of resonators (108, 208) are not parallel to each other, cross coupling may occur between non-adjacent resonators (108, 208).

The foregoing description is merely illustrative of the technical idea of the present embodiments, and various modifications and variations may be made by those of ordinary skill in the art without departing from essential responses of the present embodiments. Accordingly, the present embodiments are intended to illustrate, but not to limit, the technical idea of the present embodiments, and the scope of the technical idea is not limited by these embodiments. The scope of protection of the present embodiments should be interpreted according to the appended claims, and all technical ideas within the equivalent scope thereof should be construed as being included in the scope of rights of the present embodiments.

### Description of Reference Numerals

20: Second ring member
100: Ground member
101: First ring member
103: Lower surface of the ground member
107: Wall member
108: Plurality of resonators
109: Body
110: Head portion
111: Input port
113: Output port
120: Housing
121: upper case
122: lower case
280: Groove
315: Passage
550: Penetration member

### CROSS-REFERENCE TO RELATED APPLICATION

This patent application claims priority to Korean Patent Application No. 10-2023-0107242, filed on August 16, 2023, which is incorporated herein by reference in its entirety.

## Claims

1. A filter device, comprising:
a housing;
a ground member disposed inside the housing and having one side in contact with the housing;
a wall member in contact with an inner surface of the housing;
a first ring member having an inner circumferential surface in contact with the ground member;
a second ring member having an outer circumferential surface in contact with the housing;
a plurality of resonators disposed between the first ring member and the second ring member and disposed on straight lines extending in a radial direction from a center of the housing;
an input port connected to one of the plurality of resonators; and
an output port connected to another one of the plurality of resonators,
wherein the plurality of resonators is disposed to be spaced apart from each other, and
at least one of the plurality of resonators has one side in contact with the first ring member.

2. The filter device of claim 1, wherein
at least one of the plurality of resonators is electrically connected to a non-adjacent resonator.

3. The filter device of claim 1, wherein
the ground member has another side that is not in contact with the housing.

4. The filter device according to claim 1, wherein
each of the plurality of resonators comprises a head portion for adjusting frequency responses.

5. The filter device according to claim 1, wherein
a resonator among the plurality of resonators that is in contact with the first ring member is not in contact with the second ring member.

6. The filter device according to claim 5, wherein
the resonator among the plurality of resonators that is in contact with the first ring member comprises a head portion at another side.

7. The filter device according to claim 1, wherein
one or more of the plurality of resonators are not in contact with the first ring member, and
a resonator among the plurality of resonators that is not in contact with the first ring member has one side in contact with the second ring member.

8. The filter device according to claim 7, wherein
the resonator among the plurality of resonators that is in contact with the second ring member comprises a head portion at another side.

9. The filter device according to claim 1, wherein
a size and a shape of each of the plurality of resonators are independently formed.

10. The filter device according to claim 1, wherein
the wall member comprises a passage penetrating through the wall member to generate an electrical connection between the plurality of resonators.

11. The filter device of claim 1, further comprising
one or more penetration members penetrating the wall member.

12. The filter device of claim 1, wherein
a resonator connected to the input port and a resonator connected to the output port are disposed adjacent to each other.

13. The filter device of claim 12, wherein
the wall member is disposed between the resonator connected to the input port and the resonator connected to the output port.

14. The filter device of claim 1, wherein
a cross section of the ground member that is perpendicular to a longitudinal direction of the ground member has a polygonal shape.

15. The filter device according to claim 1, wherein
the plurality of resonators are arranged such that resonators in contact with the first ring member and resonators in contact with the second ring member are alternately arranged.

16. The filter device according to claim 1, wherein
the plurality of resonators comprises first to fifth resonators disposed sequentially along a counterclockwise direction about the first ring member,
the first resonator is connected to the input port,
the fifth resonator is connected to the output port,
the first resonator, the third resonator, and the fifth resonator are in contact with the second ring member, and
the second resonator and the fourth resonator are in contact with the first ring member.

17. The filter device according to claim 16, wherein
the wall member is positioned between the first resonator and the fifth resonator, and
the wall member comprises a passage penetrating through the wall member to generate an electrical connection between the plurality of resonators.

18. The filter device according to claim 1, wherein
the plurality of resonators comprises first to fifth resonators disposed sequentially along a counterclockwise direction about the ground member,
the first resonator is connected to the input port,
the fifth resonator is connected to the output port,
the first resonator, the third resonator, and the fifth resonator are in contact with the first ring member, and
the second resonator and the fourth resonator are in contact with the second ring member.

19. The filter device according to claim 1, further comprising
at least one penetrating member penetrating through the wall member,
wherein the plurality of resonators comprises first to fifth resonators disposed sequentially along a counterclockwise direction about the ground member,
the first resonator is connected to the input port,
the fifth resonator is connected to the output port,
the first resonator, the second resonator, the fourth resonator, and the fifth resonator are in contact with the first ring member,
the third resonator is in contact with the second ring member, and
the wall member is positioned between the first resonator and the fifth resonator.

20. A filter device, comprising:
a housing;
a ground member disposed inside the housing and having one side in contact with the housing;
a wall member in contact with an inner surface of the housing;
a first ring member having an inner circumferential surface in contact with the ground member;
a plurality of resonators extending from the first ring member;
an input port connected to one of the plurality of resonators; and
an output port connected to another one of the plurality of resonators,
wherein the plurality of resonators is disposed to be spaced apart from each other.

21. A filter device, comprising:
a housing;
a ground member disposed inside the housing and having one side in contact with the housing;
a wall member in contact with an inner surface of the housing;
a second ring member having an outer circumferential surface in contact with the housing;
a plurality of resonators extending from the second ring member;
an input port connected to one of the plurality of resonators; and
an output port connected to another one of the plurality of resonators,
wherein the plurality of resonators is disposed to be spaced apart from each other.

22. The filter device according to claim 1, wherein
the filter device is configured to be implemented in a microstrip line form or a strip line form by including at least one dielectric substrate.
